# EUROPEAN PATENT APPLICATION

(11) **EP 4 687 377 A1**
(43) Date of publication of application: **04.02.2026**
(21) Application number: 24315372.3
(22) Date of filing: 31.07.2024
(51) Int. Cl.: H05K 7/14

(54) **A CARD MODULE FOR A COMPUTING UNIT OF A HIGH-PERFORMANCE COMPUTING CABINET**

(71) Applicant: BULL SAS, 78340 Les Clayes-Sous-Bois (FR)
(72) Inventor: Halli, Sanjayakumar, 582205 Gadag, Karnataka (IN); Babu, Adarsha, 571401 Mandya, Karnataka (IN); Kumbhar, Shubham Laxman, 560068 Vishwapriya Nagar, Bangalore (IN); Mohanasundaram, Sakthivel, 635103 Bagalur, Hosur Tamilnadu (IN)
(74) Representative: Argyma

(57) **Abstract**

The invention relates to a card module (1) configured to be mounted in a computing unit (A1) comprising a chassis (A10) delimiting a card module compartment (A100), said card module comprising a chassis (10) configured to be mounted in said card module compartment (A100), said chassis (10) having a parallelepipedal shape, each side face (10E, 10F) comprising a side wall (10E1, 10F1), the card module (1) being characterized in that at least one side wall (10E1, 10F1) of the chassis (10) delimits at least one opening (10E11, 10F11) configured to insert a computing card (B1A, B1B) into a slot formed inside the card module (1) and in that the opposite side wall (10F1, 10E1) comprises on its internal face (10F12, 10E12) an internal connector (10F120, 10E120) positioned facing said at least one opening, said internal connector (10E120, 10F120) being configured to connect to an external connector (B11) of the computing card (B1A, B1B) when the computing card (B1A, B1B) is inserted into the slot up to the opposite side wall (10F1, 10E1).

## Description

The present invention relates, in general, to high-performance computing and, more specifically, to a card module for a computing unit of a HPC cabinet.

A datacenter comprises several high-performance computing cabinets, called HPC cabinets or "clusters", arranged in rows within the datacenter and configured to house computing units, such as servers, switches and routers, to organize, process and store data.

Some computing units may comprise a plurality of computing cards for processing data. These computing cards may process different types of data and have different functions like e.g., calculations, graphical processing, etc.

A computing card comprises conventionally a circuit board and several components secured to said circuit board such as processors, Dual In-Line Memory Module (DIMM), a PCIe component (GPU, FPGAs)), fans, etc. The circuit board and components are housed in a housing, for example a plastic housing and connected via an external connector protruding from the housing to an internal connector mounted inside the computing unit.

In a known solution, the computing unit comprises a chassis delimiting a card module compartment for receiving a card module. The card module comprises a chassis and computing cards which are connected inside the chassis. The full insertion of the card module chassis inside the compartment of the computing unit leads to the connection of the card module to the internal electrical circuit of the computing unit so that the computing unit can further be mounted in a HPC cabinet to be operational.

In this known solution, the chassis of the card module is open on its top face and cards are inserted through said top face directly into the chassis onto internal connectors. The cards are positioned vertically parallel and adjacent to each other, holding in place by gravity and the connection to each internal connector.

A new type of computing card, called Full Height Half Length (FHHL) card, is known in the industry, having greater dimensions, in particular being wider. Such cards can be inserted in the chassis of the existing card module, but it is not possible to insert the card module in the compartment of the computing unit as cards are now protruding outside the chassis of the card module due to their greater dimensions.

Accordingly, it is one object of the present disclosure to provide a card module which can receive cards of greater dimensions, in particular FHHL cards, and be fully inserted into the card module compartment of an existing computing unit.

### PRESENTATION OF THE INVENTION

The invention relates to a card module configured to be mounted in a computing unit for a High-Performance Computing cabinet, thereafter HPC cabinet, and for receiving at least one computing card, said computing unit comprising a chassis delimiting a card module compartment, said card module comprising a chassis configured to be mounted in said card module compartment, said chassis having a parallelepipedal shape and comprising a front face, a rear face, a bottom face, a top face, a left side face and a right side face, each side face comprising a side wall.

The card module is remarkable in that at least one side wall of the chassis delimits at least one opening configured to insert a computing card into a slot formed inside the card module and in that the opposite side wall comprises on its internal face an internal connector positioned facing said at least one opening, said internal connector being configured to connect to an external connector of the computing card when the computing card is inserted into the slot up to the opposite side wall.

The card module according to the invention allows to receive to FHHL computing cards in an easy, solid and efficient manner, while keeping the same dimensions of the chassis of the card module and thus without modifying the compartment of the computing unit of the prior art.

In one embodiment, the side wall delimiting the at least one opening comprises a flange for supporting the computing card when said computing card is inserted into the corresponding slot.

Preferably, the card module comprises a first opening on one side wall and a second opening on the opposite side wall, said first opening and second opening being misaligned to allow the insertion of two computing cards in a superimposed manner. This allows to receive two FHHL cards at the same time while optimizing the use of the space inside the card module and balancing the load inside the card module.

Preferably, the card module further comprises at least one blocking portion for blocking the computing card inside the slot.

In one embodiment, the at least one blocking portion is made of metal.

Advantageously, the at least one blocking portion is a plate.

Preferably, the at least one blocking portion is detachable.

For example, the at least one blocking portion is mounted on the side wall using screws.

Advantageously, the card module comprises a locking system configured to lock said card module inside a computing unit. The innovation allows to have the whole module as a hot swappable on the rear side of the rack.

In an embodiment, the chassis of the card module comprises at least one slit for receiving a tab of a computing card.

In an embodiment, the chassis of the card module comprises a front face comprising a front wall, said front wall comprising at least one aperture for evacuating the heat generated by a computing card.

The invention also relates to a computing unit comprising a compartment for a card module and a card module as presented before mounted into said compartment.

The invention also relates to a method for engaging a card module, as presented before, in a computing unit for High-Performance Computing cabinet, the method comprising the step of inserting a computing card in the at least one opening of a side wall until the external connector connects to the internal connector.

In one embodiment, the method comprises inserting a first computing card in the first opening until the external connector of said first computing card connects to the internal connector of the internal face of the side wall opposite to said first opening and inserting a second computing card in the second opening until the external connector of said second computing card connects to the internal connector of the internal face of the side wall opposite to said second opening.

In one embodiment, the method comprises a step of fixing a blocking portion to cover at least one part of each opening to block the computing card which has been inserted through said opening inside the card module.

### DRAWINGS

A better understanding of embodiments of the present disclosure (including alternatives and/or variations thereof) may be obtained with reference to the detailed description of the embodiments along with the following drawings, in which:
FIG. 1 is an isometric view of a HPC cabinet comprising several computing units.
FIG. 2 is an isometric view of a computing unit.
FIG. 3 is a partial view of the computing unit of FIG. 2 showing a withdrawn card module.
FIG. 4 is an isometric view of a computing card.
FIG. 5 is an isometric view of an empty card module from the front.
FIG. 6 is a view of the internal face of the left side wall of the card module.
FIG. 7 is a view of the internal face of the right side wall of the card module
FIG. 8 shows the card module of Figure 5 with the blocking portions detached.
FIG. 9 is the card module of Figure 6 showing two cards being partly inserted.
FIG. 10 is the card module of Figure 6 showing two cards being fully inserted.
FIG. 11 is the card module of Figure 8 with the blocking portions being screwed.
FIG. 12 shows the insertion of the card module inside the compartment of the computing unit.

### DETAILED DESCRIPTION

Reference will now be made in detail to specific embodiments or features, examples of which are illustrated in the accompanying drawings. Wherever possible, corresponding or similar reference numbers will be used throughout the drawings to refer to the same or corresponding parts. Moreover, references to various elements described herein are made collectively or individually when there may be more than one element of the same type. However, such references are merely exemplary in nature. It may be noted that any reference to elements in the singular may also be construed to relate to the plural and vice-versa without limiting the scope of the disclosure to the exact number or type of such elements unless set forth explicitly in the appended claims.

A datacenter comprises several high-performance computing cabinets, called HPC cabinets or "clusters", arranged in rows within the datacenter and configured to house computing units, such as servers, switches and routers, to organize, process and store data. A HPC cabinet is configured to accommodate multiple server units, switches, cords and cables, rails, cable management bars, routers, path panels, and blanking panels.

High performance computing has gained importance in recent years by several industries which are trending towards increasing sizes or combinations of two or more servers to achieve faster processing performance for a large number of processing operations. Solutions known to address such requirement of the industries include Ultra Path Interconnect (UPI) technology which provides a scalable multiprocessor system, for example, by linking motherboards of two or more computing units together.

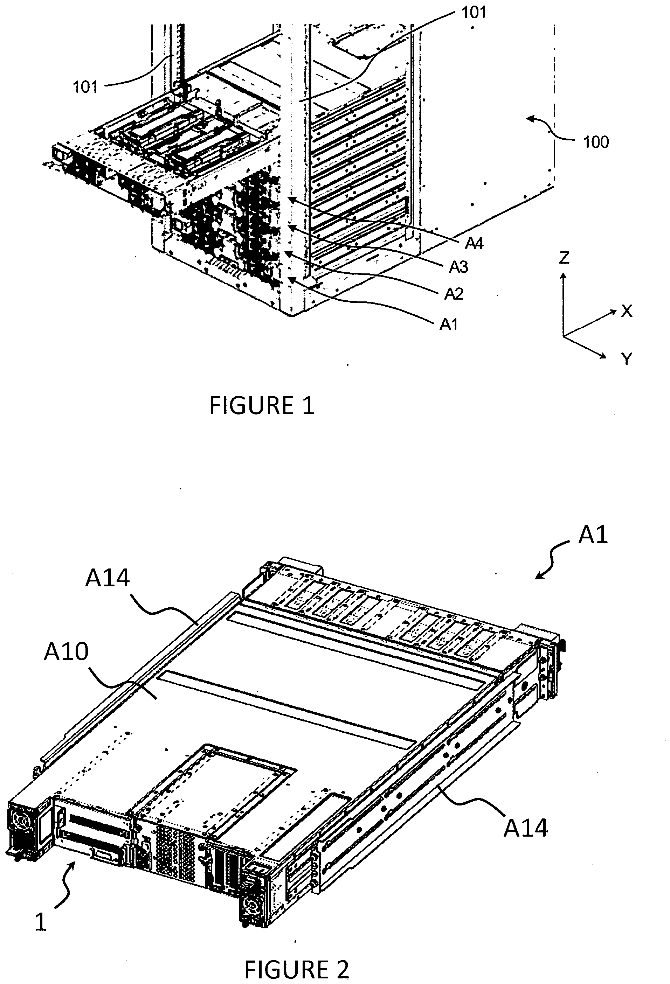

As illustrated in Figure 1, a HPC cabinet 100 comprises two vertical side walls 101, delimiting a central cavity with a front opening, so as to define vertically stacked sockets having a standard height (U). Several computing units A1-A4 are housed in the HPC cabinet 100 and mounted onto the two vertical side walls 101.

In this example, the HPC cabinet 100 comprises four computing units A1-A4. The computing units A1-A4 are presented in the (X, Y, Z) referential in which the X axis extends longitudinally from the front to the rear, the Y axis extends laterally from the left to the right and the Z axis extends vertically from the bottom to the top.

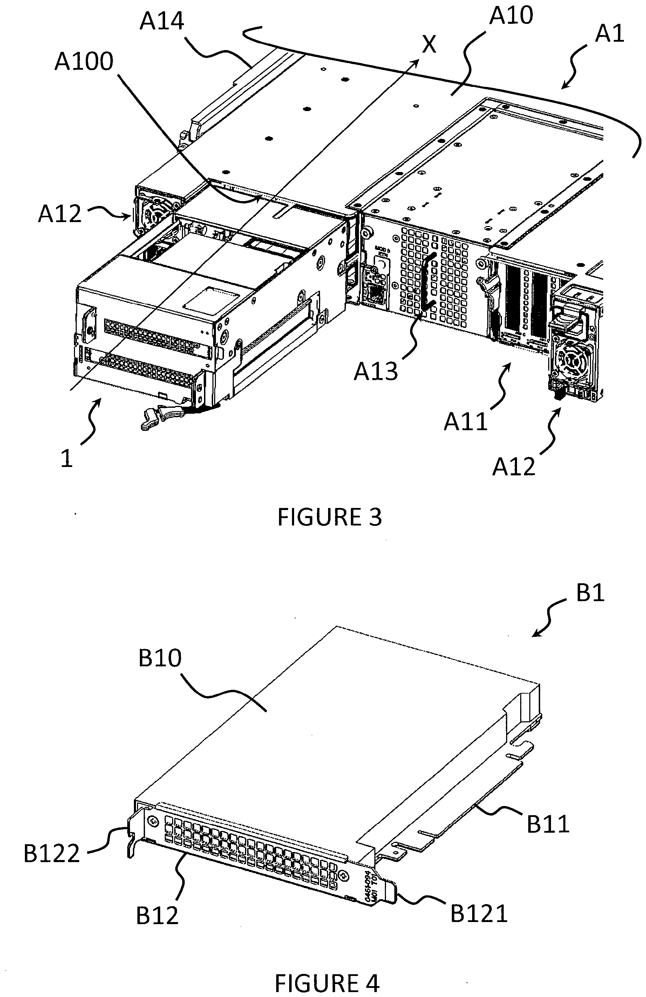

All the computing units A1-A4 are similar and only the computing unit A1 is described in Figures 2 and 3. The computing unit A1 can be a server, a switch or other.

In reference to Figure 2, the computing unit A1 comprises a chassis A10 in which is mounted an embodiment of card module 1 according to the invention.

In reference to Figure 3, the computing unit A1 comprises rear connectors A11, air outlets A12, a pulling handle A13 and rails A14 (also visible on Figure 2) on each side for mounting the computing unit A1 into the HPC cabinet 100, in a known manner. The chassis A10 delimits a compartment A100 in which is located the card module 1.

Figure 4 illustrates an example of Full Height Half Length computing card B1. The computing card B1 comprises a housing B10, for example in plastic material, defining an internal space in which is mounted a circuit board with electronic components (not visible on Figure 4). The computing card B1 comprises an external connector B11 extending from the housing B10 and configured to connect with an internal connector 10E120, 10F120 of the card module 1 as described here after. The computing card B1 comprises a metallic fixing portion B12 configured to be mounting with a screw (or several screws) to a mounting portion of the card module 1 as described here after. To this end, the fixing portion B12 comprises a first tab B121 and a second tab B122.

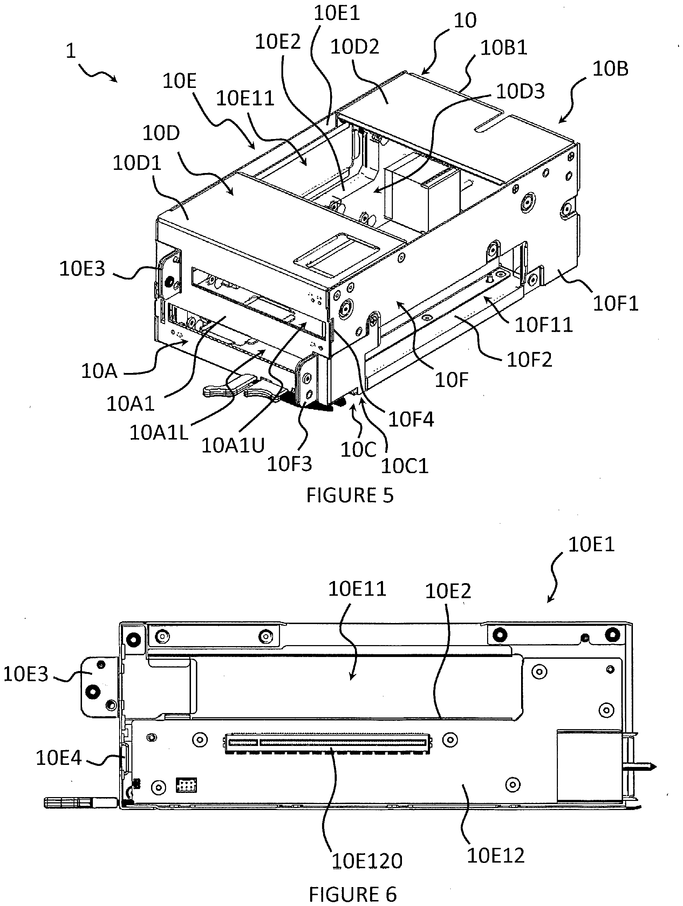

A card module 1 according to an embodiment of the invention will be described in reference to Figures 5 to 12. The card module 1 comprises a chassis 10 configured to be engaged horizontally, from the front to the rear along the X axis, within the compartment A100 defined in each computing unit A1-A4.

The chassis 10 of the card module 1 has a parallelepipedal shape and comprises a front face 10A, a rear face 10B, a bottom face 10C, a top face 10D and two side faces: a left side face 10E and a right side face 10F, all defined in the position of the card module 1 as shown on figures 5 to 11.

In this example, the chassis 10 defines an internal hollow space configured to receive two computing cards 1.

As illustrated on Figure 5, the front face 10A comprises a metallic front wall 10A1 with two horizontal apertures: an upper aperture 10A1U located in the upper part and a lower aperture 10A1L located in the lower part. The rear face 10B comprises a rear wall 10B1. The bottom face 10C comprises a bottom wall 10C1. The top face 10D comprises a front wall 10D1 and a rear wall 10D2 separated by an opening 10D3 to evacuate the heat generated by the computing cards 1.

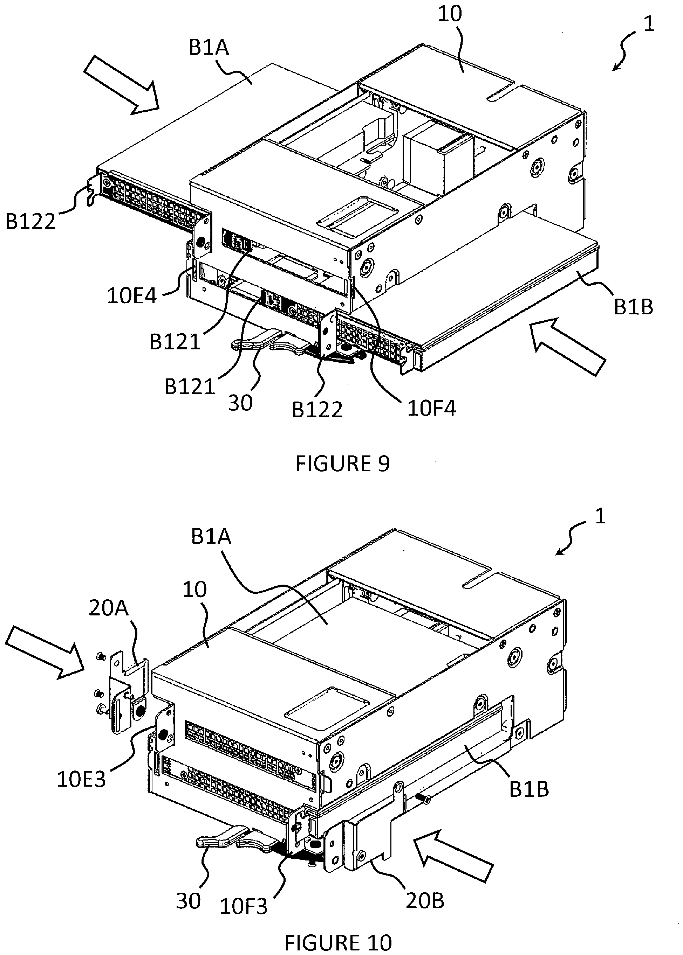

The left side face 10E comprises a side wall 10E1, which delimits in its upper part a first opening 10E11 of rectangular shape. The right side face 10F comprises a side wall 10F1, which delimits in its lower part a second opening 10F11 of rectangular shape. The first opening 10E11 and the second opening 10F11 are each dimensioned to receive by insertion respectively a first computing card B1A and a second computing card B1B (as shown on Figure 9) that is to be placed into a slot formed inside the card module chassis 10.

The location of the first opening 10E11 and of the second opening 10F11 respectively in the upper part of the left side wall 10E1 and in the lower part of the right side wall 10F1 allows to have the first computing card B1A and the second computing card B1B stored horizontally in a superimposed manner inside the chassis 10 while being inserted on each side, balancing therefore the load inside the card module 1.

As shown on Figure 6, the left side wall 10E1 comprises on its internal face 10E12 in its lower part an internal connector 10E120 facing the second opening 10F11 as shown on Figure 5.

The internal connector 10E120 of the left side wall 10E1 is configured to receive the external connector B11 of the second computing card B1B when said second computing card B1B is fully inserted inside the card module chassis 10 through the second opening 10F11.

In this example, the left side wall 10E1 comprises a flange 10E2 positioned internally under the first opening 10E11 for supporting the first computing card B1A when the first computing card B1A is inserted into the first opening 10E11.

The left side wall 10E1 also comprises a fixing mean 10E3 for mounting the second tab B122 of the first computing card B1A and a left slit 10E4 for receiving the first tab B121 of the second computing card B1B.

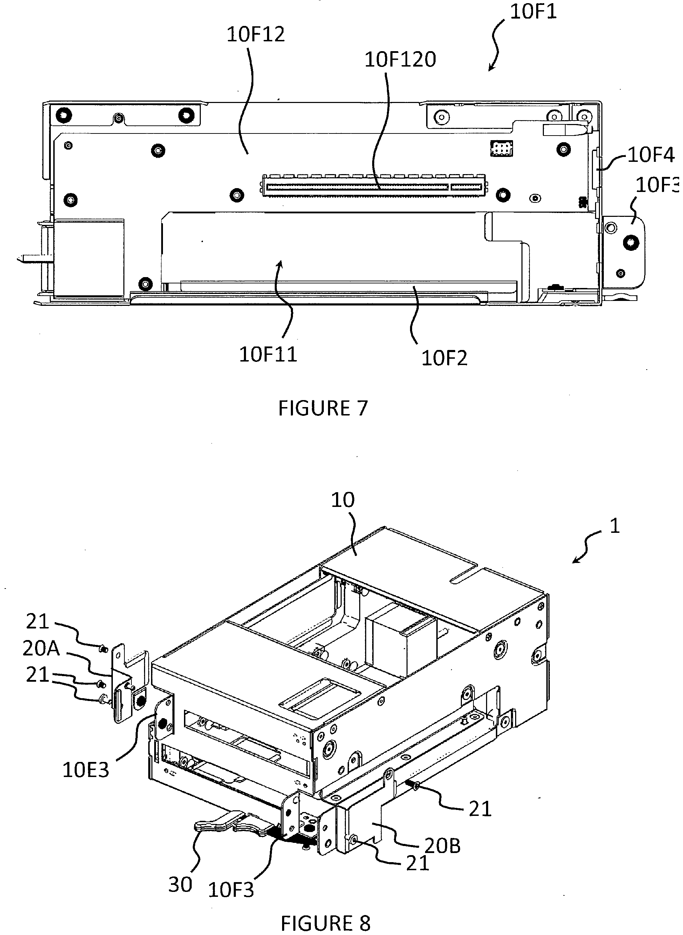

Similarly, as shown on Figure 7, the right side wall 10F1 comprises on its internal face 10F12 in its upper part an internal connector 10F120 facing the first opening 10E11 as shown on Figure 5.

The internal connector 10F120 of the right side wall 10F1 is configured to receive the external connector B11 of the first computing card B1A when said first computing card B1A is fully inserted inside the card module chassis 10 through the first opening 10E11.

The right side wall 10F1 comprises a flange 10F2 positioned internally under the second opening 10F11 for supporting the second computing card B1B when the second computing card B1B is inserted into the second opening 10F11.

The right side wall 10F1 also comprises a fixing mean 10F3 for mounting the second tab B122 of the second computing card B1B and a right slit 10F4 for receiving the first tab B121 of the first computing card B1A.

In reference to Figure 8, the card module 1 comprises a first blocking portion 20A for blocking the first computing card B1A when received and connected inside the first slot and a second blocking portion 20B for blocking the second computing card B1B when received and connected inside the second slot.

In this example, the first blocking portion 20A and the second blocking portion 20B are metallic plates that are fixed respectively on the fixing mean 10E3 of the left side wall 10E1 and on the fixing mean 10F3 of the right side wall 10F1 using screws 21.

The card module 1 comprises a locking system 30 (figures 8 to 12) configured to lock said card module 1 inside the compartment A100 of the computing unit A1.

When cards 1 need to be inserted into the empty card module 1 of Figure 5, the first blocking portion 20A and the second blocking portion 20B are unscrewed and detached as shown on Figure 8.

In reference now to Figure 9, the first computing card B1A is then inserted through the first opening 10E11 (figure 5), supported by the flange 10E2 (figure 5) until the external connector B11 of said first computing card B1A connects with the internal connector 10F120 of the right side wall 10F1.

Similarly, the second computing card B1B is inserted through the second opening 10F11 (figure 5), supported by the flange 10F2 (figure 5) until the external connector B11 of said second computing card B1B connects with the internal connector 10E120 of the left side wall 10E1.

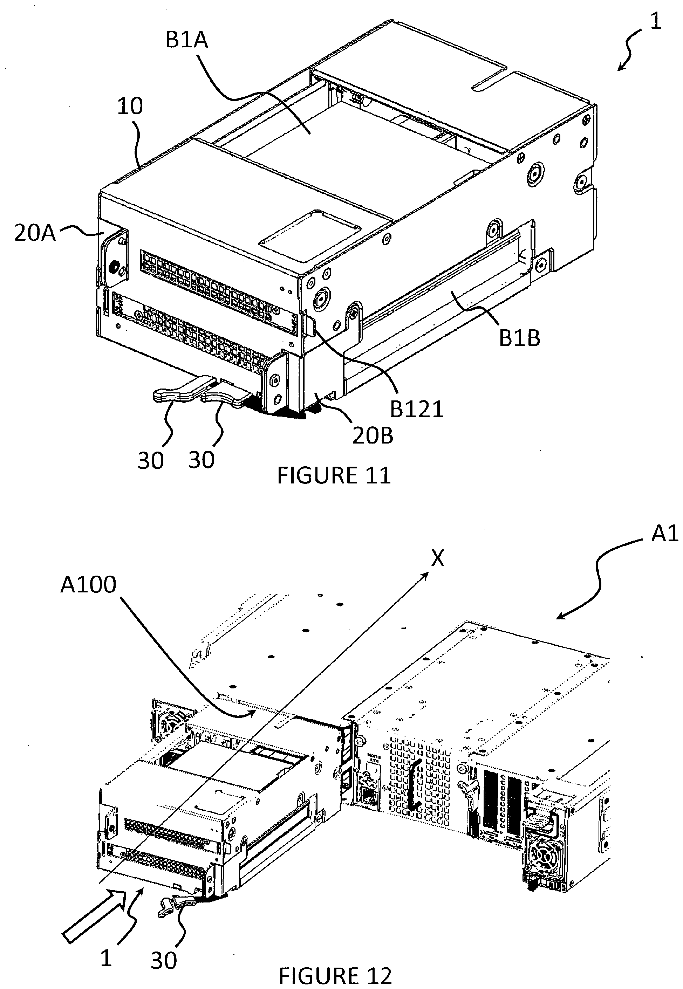

As shown on Figures 10 and 11, the first blocking portion 20A and the second blocking portion 20B are then screwed back onto respectively the fixing mean 10E3 of the left side wall 10E1 and the fixing mean 10F3 of the right side wall 10F1 and onto respectively the second tab B122 of the fixing portion B12 of the first computing card B1A and on the second tab B122 of the fixing portion B12 of the second computing card B1B, fixing thus solidly the first computing card B1A and the second computing card B1B to the chassis 10.

All terminologies used herein are for purposes of describing embodiments and examples and should not be construed as limiting the invention. As used herein, the singular forms "a," "an," and "the" are intended to include the plural forms as well, unless the context clearly indicates otherwise.

Furthermore, to the extent that the terms "including," "includes," "having," "has," "with," or variants thereof, are used in either the detailed description and/or the claims, such terms are intended to be inclusive in a manner similar to the term "comprising."

Unless otherwise defined, all terms (including technical and scientific terms) used herein have the same meaning as commonly understood by the person skilled in the art to which this present disclosure belongs.

Furthermore, terms, such as those defined in commonly used dictionaries, should be interpreted as having a meaning that is consistent with their meaning in the context of the relevant art and will not be interpreted in an idealized or overly formal sense unless expressly defined herein.

While aspects of the present disclosure have been particularly shown and described with reference to the embodiments above, it will be understood by those skilled in the art that various additional embodiments may be contemplated by the modification of the disclosed methods without departing from the spirit and scope of what is disclosed.

Such embodiments should be understood to fall within the scope of the present disclosure as determined based upon the claims and any equivalents thereof.

## Claims

1. A card module (1) configured to be mounted in a computing unit (A1) for a High-Performance Computing cabinet (100), thereafter HPC cabinet (100), and for receiving at least one computing card (B1A, B1B), said computing unit (A1) comprising a chassis (A10) delimiting a card module compartment (A100), said card module (1) comprising a chassis (10) configured to be mounted in said card module compartment (A100), said chassis (10) having a parallelepipedal shape and comprising a front face (10A), a rear face (10B), a bottom face (10C), a top face (10D), a left side face (10E) and a right side face (10F), each side face (10E, 10F) comprising a side wall (10E1, 10F1), the card module (1) being **characterized in that** at least one side wall (10E1, 10F1) of the chassis (10) delimits at least one opening (10E11, 10F11) configured to insert a computing card (B1A, B1B) into a slot formed inside the card module (1) and **in that** the opposite side wall (10F1, 10E1) comprises on its internal face (10F12, 10E12) an internal connector (10F120, 10E120) positioned facing said at least one opening (10E11, 10F11), said internal connector (10E120, 10F120) being configured to connect to an external connector (B11) of the computing card (B1A, B1B) when the computing card (B1A, B1B) is inserted into the slot up to the opposite side wall (10F1, 10E1).

2. A card module (1) according to claim 1, comprising a first opening (10E11) on one side wall (10E1) and a second opening (10F11) on the opposite side wall (10F1), said first opening (10E1 1) and second opening (10F11) being misaligned to allow the insertion of two computing cards (B1A, B1B) in a superimposed manner.

3. A card module (1) according to any one of claims 1 or 2, further comprising at least one blocking portion (20A, 20B) for blocking the computing card (B1A, B1B) inside the slot.

4. A card module (1) according to claim 3, wherein the at least one blocking portion (20A, 20B) is made of metal.

5. A card module (1) according to any one of claims 3 or 4, wherein the at least one blocking portion (20A, 20B) is a plate.

6. A card module (1) according to any one of claims 3 to 5, wherein the at least one blocking portion (20A, 20B) is detachable.

7. A card module (1) according to the preceding claim, wherein the at least one blocking portion (20A, 20B) is mounted on the side wall (10E1, 10F1) using screws (21).

8. A card module (1) according any of the preceding claims, wherein the side wall (10E1, 10F1) delimiting the at least one opening (10E11, 10F11) comprises a flange (10E2, 10F2) for supporting the computing card (B1A, B1B) when said computing card (B1A, B1B) is inserted into the corresponding slot.

9. A card module (1) according any of the preceding claims, comprising a locking system (30) configured to lock said card module (1) inside a computing unit (A1).

10. A card module (1) according any of the preceding claims, comprising at least one slit (10E4, 10F4) for receiving a tab (B121) of a computing card (B1A, B1B).

11. A card module (1) according any of the preceding claims, wherein the front face (10A) comprises a front wall (10A1), said front wall (10A1) comprising at least one aperture (10A1L, 10A1U) for evacuating the heat generated by a computing card (B1A, B1B).

12. A computing unit (A1) comprising a compartment (A100) for a card module .(1) and a card module (1) according to any one of the preceding claims mounted into said compartment (A100).

13. A method for engaging a card module (1) according to any one of the claims 1 to 12, in a computing unit (A1) for a High-Performance Computing cabinet (100), the method comprising the step of inserting a computing card (B1A, B1B) in the at least one opening (10E11, 10F11) of a side wall (10E1, 10F1) until the external connector (B11) connects to the internal connector (10E120, 10F120).

14. The method of claim 13, using the card module of claim 3, comprising inserting a first computing card (B1A) in the first opening (10E11) until the external connector (B11) of said first computing card (B1A) connects to the internal connector (10F120) of the internal face (10F12) of the side wall (10F1) opposite to said first opening (10E11) and inserting a second computing card (B1B) in the second opening (10F11) until the external connector (B11) of said second computing card (B1B) connects to the internal connector (10E120) of the internal face (10E12) of the side wall (10E1) opposite to said second opening (10F11).

15. The method according to any of claims 13 or 14, further comprising a step of fixing a blocking portion (20A, 20B) to cover at least one part of each opening (10E11, 10F11) to block the computing card (B1A, B1B) which has been inserted through said opening (10E11, 10F11) inside the card module (B1A, B1B).
